# FASCICULE DE BREVET EUROPEEN

(11) **EP 0 815 562 B1**
(45) Date de publication et mention de la délivrance du brevet: **03.07.2002**
(21) Numéro de dépôt: 97900253.2
(22) Date de dépôt: 09.01.1997
(51) Int. Cl.: G11C 19/28, G09G 3/36

(54) **PERFECTIONNEMENT AUX REGISTRES A DECALAGE UTILISANT DES TRANSISTORS "MIS" DE MEME POLARITE**
VERBESSERTES SCHIEBEREGISTER MIT MIS-TRANSISTOREN DER GLEICHEN PRIORITÄT
IMPROVEMENT TO SHIFT REGISTERS USING MIS TRANSISTORS HAVING THE SAME POLARITY

(30) Priorité: 11.01.1996 FR 9600260
(43) Date de publication de la demande: 07.01.1998
(60) Demande divisionnaire: 01119573.2
(73) Titulaire: Thales Avionics LCD S.A., 75800 Paris (FR)
(72) Inventeur: MAURICE, François, F-92050 Paris-La Défense Cédex (FR); LEBRUN, Hugues, F-92050 Paris-La Défense Cédex (FR); SANSON, Eric, F-92050 Paris-La Défense Cédex (FR)
(74) Mandataire: Ruellan-Lemonnier, Brigitte
(86) Numéro de dépôt international: FR9700038
(87) Numéro de publication internationale: WO9725716

(56) Documents cités:
- FR-A- 2 720 185

## Description

La présente invention concerne les registres à décalage utilisant des transistors "MIS" (pour Métal, Isolant, Semiconducteur) de même polarité. Elle concerne plus particulièrement un perfectionnement aux registres à décalage utilisant un nombre limité de transistor "MIS" de même polarité et permettant la sélection des lignes de pixels d'un écran plat.

Un écran plat, notamment un écran plat à cristaux liquides, est constitué d'un certain nombre de cellules électro-optiques arrangées en lignes et en colonnes commandées chacune par un dispositif de commutation et comportant deux électrodes encadrant un cristal liquide dont les propriétés optiques sont modifiées en fonction de la valeur du champ qui le traverse. L'ensemble constitué par le dispositif de commutation, l'électrode, le cristal liquide, la contre-électrode constitue ce que l'on appelle un "pixel" ou point image. L'adressage de ces pixels s'effectue par l'intermédiaire de lignes de sélection qui commandent l'état passant et non-passant des dispositifs de commutation et de colonnes ou lignes de données qui transmettent, lorsque le dispositif de commutation est passant, une tension appliquée aux bornes des électrodes correspondant au signal de données à afficher, à savoir à une échelle de gris.

Selon un mode de réalisation particulièrement avantageux, les électrodes, les dispositifs de commutation, les lignes et les colonnes sont déposées et gravées sur une même plaque substrat de manière à constituer la matrice active de l'écran. Dans ce cas, les circuits de commande périphérique, c'est-à-dire le balayeur de lignes de sélection qui sélectionne les lignes horizontales à afficher et les circuits qui commandent les colonnes peuvent être directement intégrés sur la plaque substrat comportant la matrice active et fabriqués en même temps que celle-ci. Ceux-ci imposent donc, notamment lorsque le nombre de pixels est très élévé, d'avoir des circuits de commande les plus petits et les plus simples possible afin d'arriver à un haut degré de rendement de fabrication. Il peut par ailleurs être avantageux d'utiliser des dispositifs semiconducteurs comme dispositifs de commutation des pixels du même type de conductivité dans tout l'afficheur.

La commande des dispositifs semi-conducteurs peut être faite par des lignes adressées par un ou plusieurs registres à décalage. Une structure de registre à décalage permettant notamment de répondre aux exigences de simplicité évoquées dans le paragraphe précédent a été décrite dans la demande de brevet internationale WO 92/15992 déposée au nom de THOMSON-LCD. Dans ce cas, un étage d'un registre à décalage comporte six transistors et est alimenté par deux signaux d'horloge ainsi que par deux sources positives et une source négative. Le fonctionnement de ce registre repose sur le fait que la grille du transistor qui commande la sortie de l'étage du registre est laissée flottante et qu'ainsi son potentiel suit, par effet capacitif le potentiel de l'horloge et de la sortie. Cet effet est appelé effet "bootstrap" en langue anglaise. Il permet au moment voulu, la charge complète de la sortie au potentiel le plus élevé de l'horloge. A ce transistor de sortie sont associés un transistor permettant de précharger la grille du transitor de sortie et un transistor permettant de la décharger. D'autre part, le fonctionnement de ces trois transistors est tel que si l'effet "bootstrap" permet une bonne charge des sorties, il s'accompagne d'effets parasites qui nécessitent l'utilisation de trois transistors supplémentaires. Un autre inconvénient réside dans le fait que certains transistors subissent en permanence un stress de grille, à savoir une tension positive sur la grille qui peut avoir pour conséquence une dérive de leur tension de seuil et entraîner à terme un disfonctionnement de l'ensemble du dispositif.

Pour remédier aux inconvénients ci-dessus, on a proposé dans la demande de brevet français n° 94 05987 déposée le 17 mai 1994 au nom de THOMSON-LCD des circuits plus simples à trois ou quatre transistors présentant des durées de vie rallongées.

Ainsi, comme représenté sur la figure 1 qui correspond à la figure 2 de la demande de brevet français N° 94 05987, un étage 21 d'un registre à décalage permettant de commander les lignes de sélection est constitué de trois transistors TI, Tp et Td. Dans ce cas, le transistor Tl commande le noeud D de la sortie sur la ligne J. Il est préchargé par le transistor Tp et déchargé par le transistor Td. De manière plus précise, l'étage 21 est connecté en 22 à la ligne précédente J-1 par le drain du transitor Tp. La grille du transistor Tp est connecté à son drain tandis que sa source est connectée au point G lui-même connecté à la grille du transistor TI. D'autre part, le point G est relié à une tension négative V- par l'intermédiaire du transistor de décharge Td, lui-même commandé par le potentiel de la ligne J + 1 connectée en sortie de l'étage suivant. De plus, le noeud D est connecté à la source du transistor TI, au noeud G par l'intermédiaire d'une capacité Cb et à la ligne J à sélectionner dont la charge est symbolisée électriquement par une capacité Cl reliée à la masse 32. Un signal d'horloge φ1 est appliqué sur le drain du transistor de sortie TI. Il existe entre le drain et la grille de ce transistor, une capacité parasite Cp responsable de l'effet "bootstrap" expliqué avec référence à la demande WO 92/15992. D'autre part dans ce shéma, une horloge φ2 exactement complémentaire de l'horloge φ1 est connectée au noeud G par l'intermédiaire d'une capacité C2 d'une valeur équivalente à celle de la capacité parasite Cp.

Ainsi les effets parasites, conséquence de l'effet "bootstrap" sont contre-balancés grâce à la liaison de l'horloge φ2 (complémentaire de l'horloge φ1) avec la grille du transistor Tp par l'intermédiaire de la capacité C2 de valeur Ct équivalente à celle de Cp. Les deux horloges étant exactement complémentaires, elles n'induisent aucune tension parasite au noeud G, à savoir sur la grille du transistor TI. Un circuit équivalent comporte une capacité Cl = 2 x Ct entre le noeud G et la masse 32. Une telle structure réduisant l'effet "bootstrap" il est nécessaire d'ajouter une capacité "bootstrap" Cb entre le noeud source D et le noeud grille G afin que la tension de la grille suive une fraction Cb/(Cb + 2xCp) des variations de la tension de source. Ainsi, il suffit, pour qu'un ratio de "bootstrap" de 60% soit atteint, que Cb ait trois fois la valeur de Ct. Le circuit décrit ci-dessus conserve l'effet "bootstrap" sans ses effets secondaires. La durée de vie du circuit et donc de l'ensemble du dispositif est rallongée alors que le nombre de transistors nécessaires a été divisé par deux par rapport à l'art antérieur.

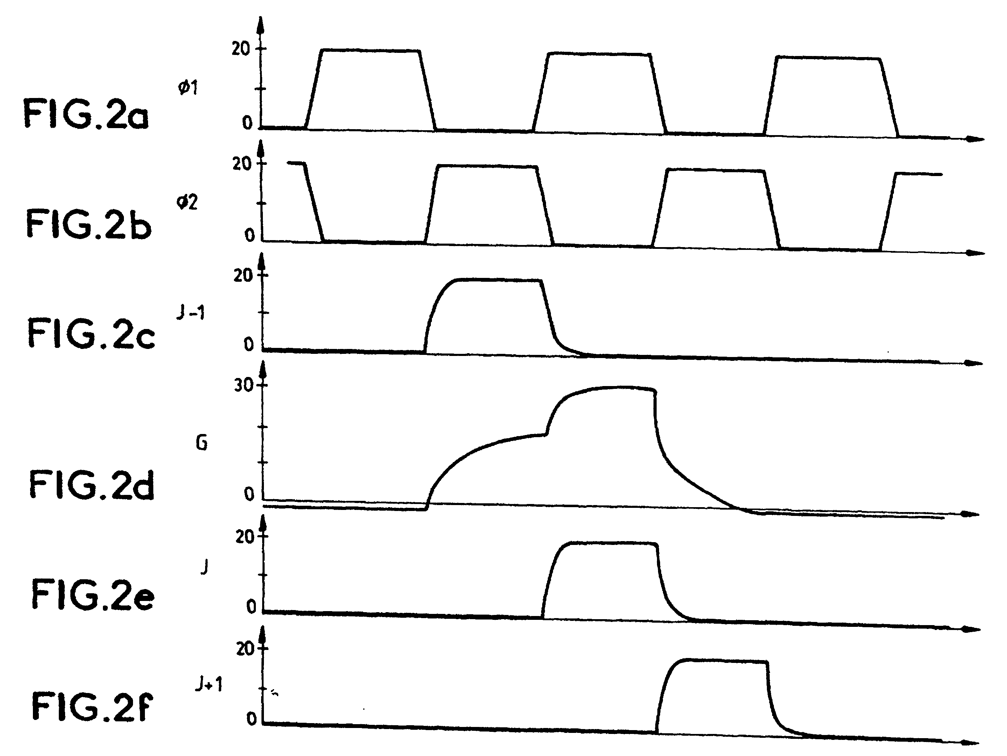

Le fonctionnement du circuit est expliqué avec référence aux chronogrammes 2a à 2f chacun d'eux montrant en abscisse une échelle de temps et en ordonnée un potentiel. Lorsque l'étage J-1 précédent envoie une impulsion (figure 2c) en 22, le transistor de précharge Tp est passant et charge la capacité de "bootstrap" Cb. Le potentiel du noeud G (fig. 2d) monte jusqu'à celui de la ligne J-1 correspondant à l'étage précédent, auquel il faut retrancher sensiblement la valeur de la tension de seuil du transistor Tp. Le transistor TI est alors passant. Lorsque l'horloge φ1 monte à son tour (fig. 2a) la sortie J suit, entraînant la grille du transistor TI grâce à la capacité de "bootstrap" (fig. 2d). Le transistor TI est alors largement passant et le noeud D et la ligne J suivent parfaitement le potentiel de l'horloge φ1 (fig. 2e) jusqu'à sa descente. A ce moment, la ligne suivante J+1 monte (fig. 2f) et rend passant le transistor Td qui décharge la capacité de "bootstrap" Cb de sorte que le transistor TI n'est plus passant pour les coups d'horloge suivants (fig. 2d).

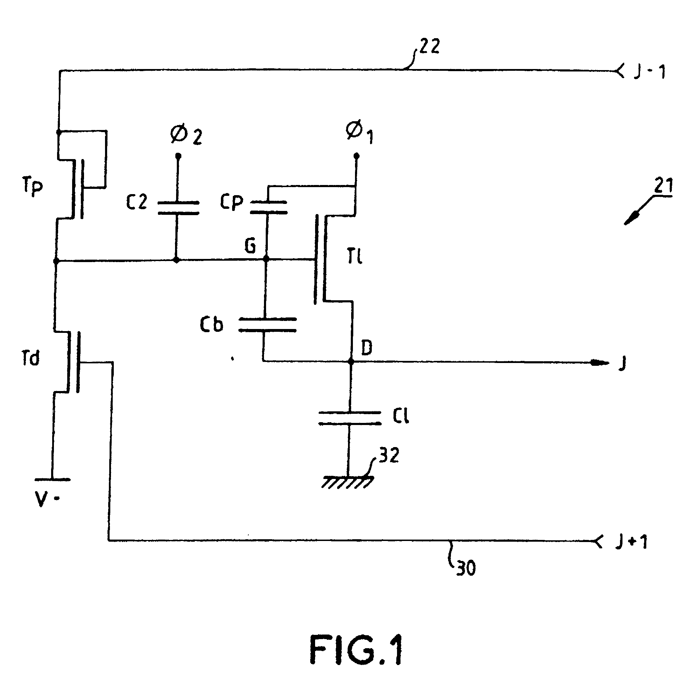

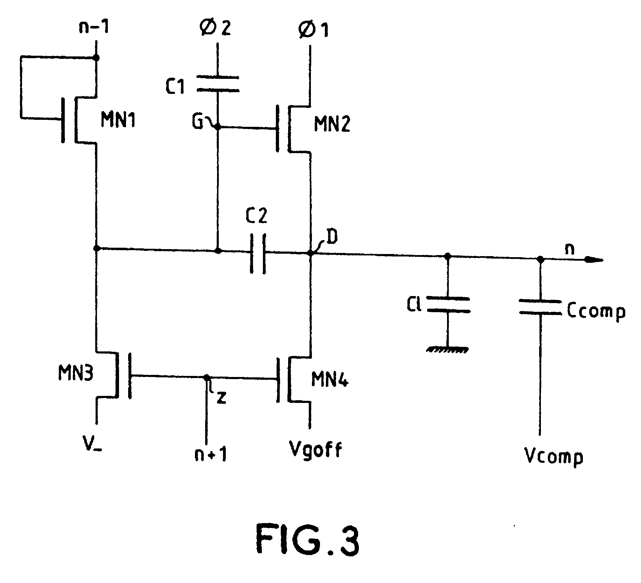

Le circuit décrit avec référence à la figure 1 a été perfectionné dans la demande de brevet français n° 94 05987 en ajoutant un transistor qui permet de travailler avec des signaux de commande ayant une amplitude de 5 à 10 volts inférieure à celle des signaux de sortie. Cette solution est représentée sur la figure 3. Sur cette figure on retrouve trois transistors MN2, MN1 et MN3 équivalents aux transistors TI, Tp et Td, les deux entrées n-1 et n+1 équivalentes à J-1 et J+1, les deux entrées d'horloge φ1 et φ2 en opposition de phase, la sortie n de l'étage équivalente à la sortie J ainsi que les capacités C1, C2 CR correspondant respectivement aux capacités C2, Cb, Cl du mode de réalisation décrit avec référence à la figure 1. Dans ce cas on prévoit un transistor de remise à zéro MN4 qui connecte le noeud D à une tension négative Vgoff. La grille du transistor MN4 est connectée au noeud Z lui-même relié à la sortie de l'étage suivant n+1 ou à la ligne n+2, c'est-à-dire à la ligne de sortie du second étage suivant. Comme décrit dans la demande française, une telle structure permet une remise à zéro avec un circuit simplifié. De plus, on a prévu entre la ligne de sortie n et une tension Vcomp, une capacité de compensation C comp.

La présente invention a pour objet d'apporter différents perfectionnements aux circuits décrits ci-dessus.

En conséquence, la présente invention a pour objet un registre à décalage comportant une pluralité d'étages en cascade, chaque étage comportant une sortie au niveau d'un premier noeud et étant connecté à la sortie de l'étage précédent, à la sortie de l'étage suivant et à des moyens fournissant des premier et second signaux d'horloge, ledit étage comportant un premier dispositif semi-conducteur de sortie commutant la sortie entre des valeurs hautes et basses du premier signal d'horloge, le premier dispositif semi-conducteur étant commandé par le potentiel d'un second noeud lui-même connecté :
- à la sortie de l'étage précédent, au travers d'un second dispositif semi-conducteur commandé par la sortie de l'étage précédent,
- à un potentiel négatif à travers un troisième dispositif semi-conducteur commandé par la sortie de l'étage suivant,
au moyen fournissant le second signal d'horloge à travers une première capacité,
caractérisé en ce qu'il comporte une capacité montée entre le second noeud et la sortie de l'étage suivant.

Cette capacité permet de retarder la descente du signal appliquée sur la grille du transistor de sortie. Cette capacité permet de remédier au fait que la taille et les caractéristiques du transistor de décharge sont critiques. En effet, le transistor de décharge doit être dimensionné de façon à ne pas décharger trop vite la grille du transistor de sortie. Si la grille du transistor de sortie est déchargée avant que l'impulsion d'horloge φ1 ne descende, alors le temps de décharge de la capacité reliée à l'horloge φ2 augmente de manière non négligeable. L'utilisation d'une capacité supplémentaire permet donc de retarder la descente de la tension appliquée sur la grille du transistor de sortie.

Selon une caractéristique supplémentaire de l'invention le registre à décalage comporte des moyens pour bloquer la tension de commande du second dispositif semi-conducteur à une valeur inférieure ou égale à zéro.

Selon un mode de réalisation préférentiel, ces moyens sont constitués par une capacité connectée entre la commande du second dispositif semi-conducteur et la sortie de l'étage précédent et un cinquième dispositif semi-conducteur connecté entre la commande du second dispositif semi-conducteur et une tension négative, le cinquième dispositif semi-conducteur étant commandé par ladite tension négative.

L'utilisation de ce dispositif permet de maintenir la commande du second dispositif semiconducteur de précharge à une tension suffisante pour empêcher toute remontée en tension de la commande du dispositif semi-conducteur de sortie.

Selon une autre caractéristique de l'invention le registre à décalage comporte des moyens pour maintenir la ligne de sortie de l'étage à un niveau bas.

Selon un mode de réalisation préférentiel, ces moyens sont constitués par un sixième dispositif semi-conducteur connecté entre la ligne de sortie et une tension négative Vgoff., le sixième dispositif semi-conducteur étant commandé par des impulsions de remise à zéro.

Cela permet de compenser les courants de fuite à travers le premier dispositif semi-conducteur.

D'autres caractéristiques et avantages de la présente invention apparaîtront à la lecture de la description de différents modes de réalisation faite ci-après avec référence aux dessins ci-annexés dans lesquels :
- la figure 1 déjà décrite représente un étage 21 d'un registre à décalage selon l'état de l'art ;
- les figures 2a à 2f représentent le chronogramme des différents signaux du dispositif de la figure 1 ;
- la figure 3 déjà décrite représente un autre mode de réalisation d'un étage d'un registre à décalage selon l'art antérieur, et
- les figures 4 à 6 représentent différents perfectionnements apportés à l'étage du registre à décalage représenté sur la figure 3.

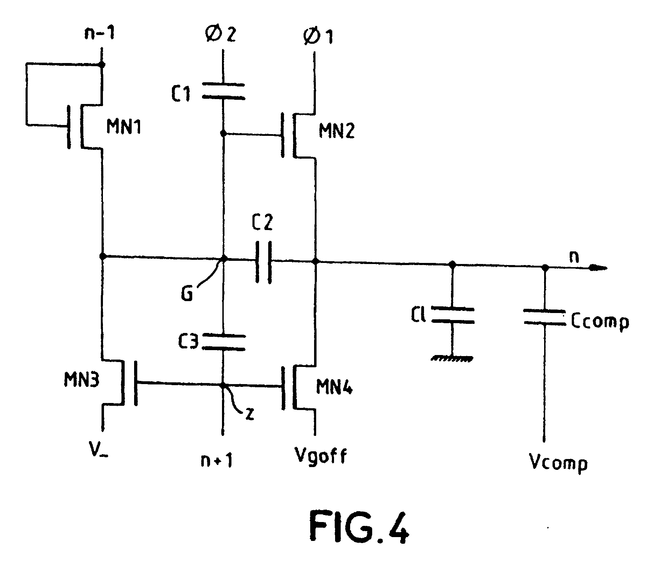

Pour simplifier la description dans les figures 4 à 6 les mêmes éléments que ceux de la figure 3, déjà décrite, portent les mêmes références.

Dans la description qui va suivre, les dispositifs semiconducteurs sont constitués par des transistors, plus particulièrement des transistors MOS et même des TFT. L'invention n'est toutefois pas limitée à ce type de transistors.

Conformément à la présente invention et, comme représentée sur la figure 4, un premier perfectionnement de l'étage d'un registre à décalage selon la figure 3 est constitué par une capacité C3 montée entre le noeud z de connexion à l'étage suivant n+1 et le noeud G. Cette capacité permet de retarder la descente de la tension appliquée sur la grille du transistor de sortie MN2. L'utilisation d'une telle capacité donne plus de marge au dimensionnement du transistor de décharge MN3 et permet d'optimiser le temps de descente de la ligne n. En effet, lorsque l'horloge Ø1 est à un niveau haut et que la ligne de sortie est à un niveau haut, la tension appliquée sur la grille du transistor MN2 a tendance à suivre la tension de sortie. Lorsque l'on désélectionne la ligne, l'horloge Ø1 passe à zéro. Le transistor MN2 étant passant, il permet à la sortie n de redescendre vers une tension basse. L'étage suivant du registre à décalage, à savoir n+1, passe à un niveau haut. Dans ce cas, les transistors MN3 et MN4 sont actifs. Le transistor MN4 a pour effet de ramener la ligne à zéro tandis que le transistor MN3 a pour effet de faire descendre la tension grille du transistor MN2. En utilisant la capacité C3, lorsque le transistor de charge MN1 devient passant, la tension au point G augmente. De ce fait, le transistor MN4 devient passant et par couplage capacitif, le transistor MN4 a tendance à suivre la tension appliquée sur le transistor MN2. De ce fait, on retarde la décharge de la grille du transistor MN2.

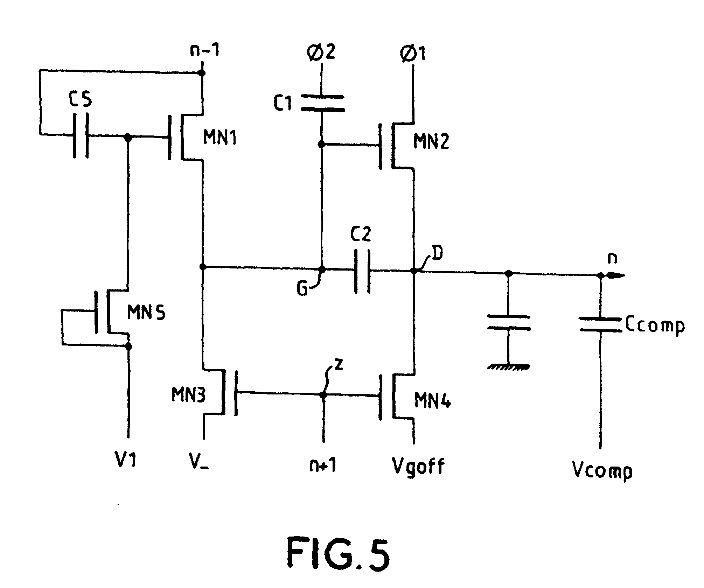

Selon un autre perfectionnement tel que représenté à la figure 5, on prévoit des moyens pour bloquer la tension de commande du second dispositif semiconducteur MN1 à une valeur inférieure ou égale à zéro. Le dispositif semiconducteur MN1 est normalement constitué dans la figure 3 par un transistor MOS monté en diode, c'est-à-dire que sa grille est connectée à son drain. Dans le perfectionnement représenté à la figure 5, on prévoit une capacité C5 montée entre la grille du transistor MN1 et le drain de ce transistor, à savoir la sortie de l'étage précédent n-1. On prévoit de plus, un dispositif semiconducteur supplémentaire MN5 constitué aussi par un transistor MOS monté en diode. Ce transistor MN5 est connecté entre la capacité C5 et la grille du transistor MN1 au niveau d'une de ses électrodes, son autre électrode étant connectée à une tension V1 qui, de préférence, est choisie telle que V1 ≤ V- ≤ Vgoff. D'autre part, la grille du transistor MN5 est connectée à V1. L'utilisation de la capacité de couplage C5 et du transistor MN5 qui fonctionne comme un transistor de fuite permet de bloquer correctement le transistor de charge MN1 de façon à ce que la tension de grille au transistor MN1 soit inférieure ou égale à zéro. En effet, par couplage capacitif entre la ligne de sortie n-1 et la grille du transistor MN1, quand la ligne de sortie n-1 descend vers zéro, on amène sur la capacité C5 une tension inférieure à zéro. De ce fait, le transistor MN1 est bien bloqué. D'autre part, le transistor MN5 sert de diode "clamp" à la tension V1 pour éviter que la tension de grille du transistor MN1 ne descende trop bas.

D'autre part, pour optimiser le fonctionnement de l'étage décrit à la figure 5, la capacité C3 décrite avec référence à la figure 4, peut être ajoutée à cet étage entre le noeud G et le noeud z.

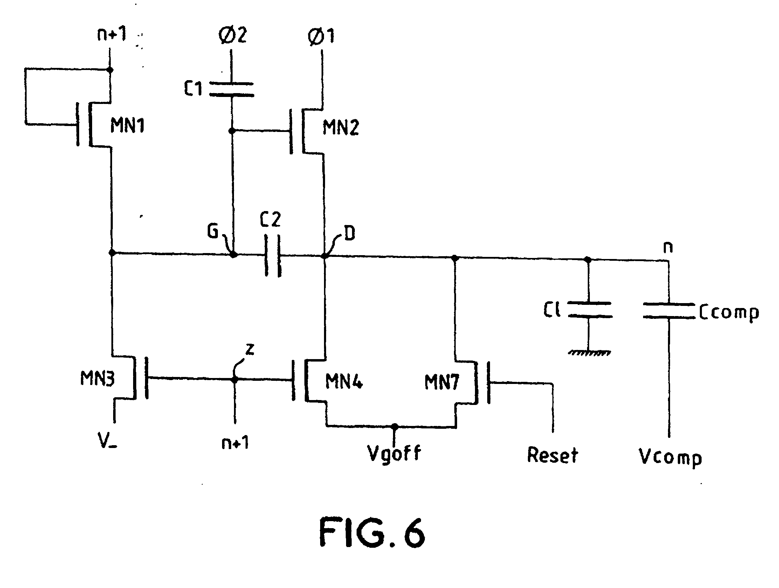

On décrira maintenant un autre perfectionnement apporté à l'étage du registre à décalage représenté à la figure 3 en se référant à la figure 6. Dans ce cas, on prévoit des moyens pour maintenir la ligne de sortie n à un niveau bas. Comme représenté sur la figure 6, ces moyens sont constitués par un sixième dispositif semiconducteur MN7 connecté entre la ligne de sortie n et une tension négative Vgoff, le sixième dispositif semiconducteur étant commandé par des impulsions de remise à zéro. De manière plus spécifique, le sixième dispositif semiconducteur est constitué par un transistor MOS MN7 dont les deux électrodes sont connectées entre la ligne de sortie n et la tension négative Vgoff et dont la grille reçoit des impulsions de remise à zéro référencées Reset.

Le transistor MOS MN7 permet de maintenir la ligne à un niveau bas indépendemmment de la fuite à travers le transistor de sortie MN2. En fait, le transistor MN7 remet à la tension négative Vgoff la capacité Cl à chaque demie période d'horloge. suffisamment faible pour ne pas charger la capacité C1 quand l'horloge devient positive. Typiquement, pour des transistors à base de silicium amorphe, V- ≤ Vgoff - 2 volts.

Il est évident pour l'homme de l'art que les différents perfectionnements décrits ci-dessus peuvent être combinés les uns avec les autres, comme mentionnés dans les revendications ci-après.

## Revendications

1. Registre à décalage comportant une pluralité d'étages en cascade (n-1, n, n+1), chaque étage (n) comportant une sortie au niveau d'un premier noeud (D) et étant connecté à la sortie de l'étage précédent (n-1), à la sortie de l'étage suivant (n+1) et à des moyens fournissant des premier et second signaux d'horloge (φ1, φ2), ledit étage comportant un premier dispositif semiconducteur de sortie (MN2) commutant la sortie (n) entre des valeurs hautes et basses du premier signal d'horloge (φ1), le premier dispositif semiconducteur étant commandé par le potentiel d'un second noeud (G), lui-même connecté :
- à la sortie de l'étage précédent (n-1) au travers d'un second dispositif semiconducteur (MN1) commandé par la sortie de l'étage précédent (n-1) ;
- à un potentiel négatif (V-) à travers un troisième dispositif semiconducteur (MN3) commandé par la sortie de l'étage suivant (n+1) ;
- au moyen fournissant le second signal d'horloge (φ2) à travers une première capacité (C2),
**caractérisé en ce qu'**il comporte une capacité (C3) montée entre le second noeud (G) et la sortie de l'étage suivant (n+1).

2. Registre selon la revendication 1, **caractérisé en ce que** la sortie (n) dudit étage est reliée à une tension négative (Vgoff) à travers un quatrième dispositif semiconducteur (MN4) commandé par la sortie de l'étage suivant (n+1) ou du second étage suivant (n+2).

3. Registre selon l'une quelconque des revendications 1 et 2, **caractérisé en ce qu'**il comporte des moyens pour bloquer la tension de commande du second dispositif semiconducteur (MN1) à une valeur inférieure ou égale à zéro.

4. Registre selon la revendication 3, **caractérisé en ce que** lesdits moyens sont constitués par une capacité connectée entre la commande du second dispositif semiconducteur (MN1) et la sortie de l'étage précédent (n-1) et un cinquième dispositif semiconducteur (MN5) connecté entre la commande du second dispositif semiconducteur (MN1) et une tension (V1), le cinquième dispositif semiconducteur (MN5) étant commandé par la tension (V1).

5. Registre selon la revendication 4, **caractérisé en ce que** la tension (V1) est choisie telle que V1 ≤ V - ≤ Vgoff.

6. Registre selon l'une quelconque des revendications 1 à 5, **caractérisé en ce qu'**il comporte des moyens pour maintenir la ligne de sortie (n) à un niveau bas.

7. Registre selon la revendication 6, **caractérisé en ce que** le moyen pour maintenir la ligne de sortie (n) à un niveau bas est constitué par un sixième dispositif semiconducteur (MN7) connecté entre la ligne de sortie et une tension négative (Vgoff), le sixième dispositif semiconducteur étant commandé par des impulsions de remise à zéro.

8. Registre selon l'une quelconque des revendications 1 à 7, **caractérisé en ce que** la sortie (n) dudit étage est reliée à une tension négative (Vgoff) à travers un quatrième dispositif semiconducteur (MN4) commandé par la sortie de l'étage suivant (n+1) ou du second étage suivant (n+2).

9. Registre selon l'une quelconque des revendications 1 à 8, **caractérisé en ce que** les dispositifs semiconducteurs sont constitués par des transistors MIS, de préférence des transistors TFT.

10. Registre selon l'une quelconque des revendications 1 à 9, **caractérisé en ce que** les signaux d'horloge (φ1,φ2) sont obtenus par un même signal d'horloge en opposition de phase.

## Patentansprüche

1. Schieberegister mit mehreren Stufen in Kaskade (n-1, n, n+1), wobei jede Stufe (n) einen Ausgang bei einem ersten Schaltungspunkt (D) enthält, der mit dem Ausgang der vorangehenden Stufe (n-1), dem Ausgang der nächsten Stufe (n+1) und mit Mitteln verbunden ist, die ein erstes und ein zweites Taktsignal (φ1, φ2) liefern, wobei die Stufe ein erstes Halbleiterelement (MN2) am Ausgang enthält, das den Ausgang (n) zwischen einem hohen und einem niedrigen Wert des ersten Taktsignals (φ1) umschaltet, und wobei das erste Halbleiterelement durch die Spannung eines zweiten Schaltungspunktes (G) gesteuert wird, der selbst verbunden ist mit:
- dem Ausgang der vorangehenden Stufe (n-1) über ein zweites Halbleiterelement (MN1), das durch den Ausgang der vorangehenden Stufe (n-1) gesteuert ist,
- einer negativen Spannung (V-) über ein drittes Halbleiterelement (MN3), das durch den Ausgang der folgenden Stufe (n+1) gesteuert wird,
- Mitteln, die das zweite Taktsignal (φ2) über eine erste Kapazität (C2) liefern,
**dadurch gekennzeichnet, daß**
es eine Kapazität (C3) enthält, die zwischen dem zweiten Schaltungspunkt (G) und dem Ausgang der nächsten Stufe (n+1) liegt.

2. Register nach Anspruch 1, **dadurch gekennzeichnet, daß** der Ausgang (n) der Stufe mit einer negativen Spannung (Vgoff) über eine vierte Halbleitereinheit (MN4) verbunden ist, die durch den Ausgang der nächsten Stufe (n+1) oder der übernächsten Stufe (n+2) gesteuert ist.

3. Register nach einem der Ansprüche 1 und 2, **dadurch gekennzeichnet, daß** es Mittel zum Sperren der Steuerspannung des Halbleiterelements (MN1) bei einem Wert kleiner oder gleich null enthält.

4. Register nach Anspruch 3, **dadurch gekennzeichnet, daß** die Mittel durch eine Kapazität gebildet sind, die zwischen einem Steuereingang der zweiten Halbleitereinheit (MN1) und dem Ausgang der vorangehenden Stufe (n-1) und einerfünften Halbleitereinheit (MN5) liegt, die zwischen dem Steuereingang der zweiten Halbleitereinheit (MN1) und einer Spannung (V1) liegt, und die fünfte Halbleitereinheit (MN5) durch die Spannung (V1) gesteuert wird.

5. Register nach Anspruch 4, **dadurch gekennzeichnet, daß** die Spannung (V1) so gewählt ist, daß V1 ≤ V - ≤ Vgoff ist.

6. Register nach einem der Ansprüche 1 bis 5, **dadurch gekennzeichnet, daß** es Mittel zum Halten der Ausgangsleitung (n) bei einem niedrigen Wert enthält.

7. Register nach Anspruch 6, **dadurch gekennzeichnet, daß** die Mittel zum Halten der Ausgangsleitung (n) bei einem niedrigen Wert durch eine sechste Halbleitereinheit (MN7) gebildet sind, die zwischen der Ausgangsleitung und einer negativen Spannung (Vgoff) liegt, und die sechste Halbleitereinheit durch die Impulse zum Rücksetzen auf null gesteuert wird.

8. Register nach einem der Ansprüche 1 bis 7, **dadurch gekennzeichnet, daß** der Ausgang (n) der Stufe mit einer negativen Spannung (Vgoff) über eine vierte Halbleitereinheit (MN4) verbunden ist, die durch den Ausgang der nächsten (n+1) oder der übernächsten Stufe (n+2) gesteuert wird.

9. Register nach einem der Ansprüche 1 bis 8, **dadurch gekennzeichnet, daß** die Halbleitereinheiten aus MIS-Transistoren, vorzugsweise aus TFT-Transistoren, bestehen.

10. Register nach einem der Ansprüche 1 bis 9, **dadurch gekennzeichnet, daß** die Taktsignale (φ1,φ2) aus demselben Signal mit entgegengesetzter Phase gewonnen werden.

## Claims

1. Shift register containing a plurality of cascaded stages (n-1, n+1), each stage (n) containing an output at a first node (D) and being connected to the output of the preceding stage (n-1), to the output of the next stage (n+1) and to means delivering first and second clock signals (φ1, φ2), the said stage containing a first output semiconductor device (MN2) switching the output (n) of said stage between high and low values of the first clock signal (φ1), the first semiconductor device being controlled by the potential of a second node (G), itself connected:
- to the output of the preceding stage (n-1) across a second semiconductor device (MN1) controlled by the output of the preceding stage (n-1);
- to a negative potential (V-) across a third semiconductor device (MN3) controlled by the output of the next stage (N+1) ;
- to the means delivering the second clock signal (φ2) across a first capacitance (C2),
wherein a capacitance (C3) is mounted between the second node (G) and the output of the next stage (n+1).

2. Register according to Claim 1, **characterized in that** the output (n) of the said stage is linked to a negative voltage (Vgoff) across a fourth semiconductor device (MN4) controlled by the output of the next stage (n+1) or of the next but one stage (n+2).

3. Register according to anyone of Claims 1 or 2, **characterized in that** it includes means for latching the control voltage of the second semiconductor device (MN1) at a value less than or equal to zero.

4. Register according to Claim 3, **characterized in that** the said means consist of a capacitance connected between the control of the second semiconductor device (MN1) and the output of the preceding stage (n-1) and a fifth semiconductor device(MN5)connected between the control of the second semiconductor device (MN1) and a voltage (V1), the fifth semiconductor device (MN5) being controlled by the said voltage (V1).

5. Register according to Claim 4, **characterized in that** the said voltage (V1) is chosen such that V1 ≤ V - ≤ Vgoff.

6. Register according to anyone of Claims 1 to 5, **characterized in that** it includes means for maintaining the output line (n) at a low level.

7. Register according to Claim 6, **characterized in that** the means for maintaining the output line (n) at a low level consist of a sixth semiconductor device (MN7) connected between the output line and a negative voltage (Vgoff), the sixth semiconductor device being controlled by reset-to-zero pulses.

8. Register according to anyone of Claims 1 to 7, **characterized in that** the output (n) of the said stage is linked to a negative voltage (Vgoff) across a fourth semiconductor device (MN4) controlled by the output of the next stage (n+1) or of the next but one stage (n+2).

9. Register according to anyone of claims 1 to 8, **characterized in that** the semiconductor devices are constituted by MIS transistors, preferably TFT transistors.

10. Register according to anyone of claims 1 to 9, **characterized in that** the clock signals (φ1, φ2) are obtained from a same clock signal with opposite phase.
